(19) **Europäisches Patentamt** / **European Patent Office** / **Office européen des brevets**

(11) **EP 2 250 731 B1**

(12) **FASCICULE DE BREVET EUROPEEN**

(45) Date de publication et mention de la délivrance du brevet:
**25.04.2012 Bulletin 2012/17**

(21) Numéro de dépôt: **09721157.7**

(22) Date de dépôt: **05.03.2009**

(51) Int Cl.:
***H03L 1/02*** *(2006.01)*

(86) Numéro de dépôt international:
**PCT/EP2009/052624**

(87) Numéro de publication internationale:
**WO 2009/112427 (17.09.2009 Gazette 2009/38)**

(54) **DISPOSITIF ET METHODE DE COMPENSATION D'UN RESONATEUR**

AUSGLEICHSVERFAHREN UND -VORRICHTUNG FÜR EINEN RESONATOR

DEVICE AND METHOD FOR COMPENSATING FOR A RESONATOR

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **10.03.2008 EP 08152548**

(43) Date de publication de la demande:
**17.11.2010 Bulletin 2010/46**

(73) Titulaire: **CSEM Centre Suisse d'Electronique et de**
**Microtechnique SA - Recherche et Développement**
**2002 Neuchâtel (CH)**

(72) Inventeur: **RUFFIEUX, David**
**CH-1789 Lugnorre (CH)**

(74) Mandataire: **GLN**
**Rue du Puits-Godet 8a**
**2000 Neuchâtel (CH)**

(56) Documents cités:
**EP-A- 1 304 804    EP-A- 1 475 885**
**JP-A- 58 173 488    JP-A- 59 105 720**
**US-A1- 2005 151 592**

- LANFRANCHI D ET AL: "A microprocessor-based analog wristwatch chip with 3 seconds/year accuracy" SOLID-STATE CIRCUITS CONFERENCE, 1994. DIGEST OF TECHNICAL PAPERS. 41S T ISSCC., 1994 IEEE INTERNATIONAL SAN FRANCISCO, CA, USA 16-18 FEB. 1994, NEW YORK, NY, USA,IEEE, 16 février 1994 (1994-02-16), pages 92-93, XP010121053 ISBN: 978-0-7803-1844-1 cité dans la demande

**Description**

Domaine technique

La présente invention se rapporte au domaine des dispositifs de compensation thermique des résonateurs piézoélectriques ou électrostatiques agencés dans des oscillateurs.

Elle concerne plus particulièrement un dispositif électronique permettant de compenser la dérive thermique de la fréquence d'un résonateur piézoélectrique ou électrostatique en silicium dans un but d'assurer la stabilité de sa fréquence de référence.

Etat de la technique

L'article de D. Lanfranchi et al., « A Microprocessor-Based Analog Wristwatch Chip with 3 Seconds/Year Accuracy », IEEE 1994, décrit un circuit permettant d'augmenter la stabilité de la fréquence nominale d'un résonateur de type quartz horloger typiquement de fréquence égale à 32 kHz. Un oscillateur est associé à ce résonateur. Il est prévu un fonctionnement en mode bi-fréquentiel de l'oscillateur : l'ajustement en fréquence est effectué en procédant à une commutation d'une capacité ajoutée à la structure de l'oscillateur, par un signal de référence externe. Ainsi l'oscillateur, qualifié de bi-fréquence, peut osciller à deux fréquences différentes : une première fréquence supérieure à la fréquence nominale et une seconde fréquence inférieure à la fréquence nominale. Il peut être défini un ratio entre les temps moyens respectifs que l'oscillateur passe aux deux fréquences haute et basse, correspondant respectivement à la première fréquence supérieure et à la seconde fréquence inférieure. L'ajustement de ce ratio est effectué au moyen d'un signal de référence. Ce signal de référence peut dériver soit d'un deuxième résonateur plus précis, soit d'un capteur de température. Le résonateur plus précis peut être utilisé de façon intermittente. Toutefois, il consomme trop pour jouer le rôle d'une base de temps servant à maintenir une horloge temps réel, appelée RTC (« Real Time Clock »). De plus, le recours à deux résonateurs n'est pas compatible avec un souci de miniaturisation maximale des dispositifs électroniques.

Il peut donc être préférable d'obtenir la base de temps en intégrant un résonateur à basse fréquence de type silicium, combiné à un capteur de température. Par exemple, le document JP 58 173488 divulgue un dispositif de compensation thermique d'un oscillateur bi-fréquence, mettant en oeuvre un compteur permettant une modification périodique de la fréquence du résonateur en fonction de la température mesurée, et donc une compensation en température de la fréquence de sortie.

Or, un dispositif dit de mode bi-fréquence ne permet de compenser les variations de la fréquence du résonateur en fonction de la température que sur une échelle correspondant à la différence dite de tirage entre la fréquence haute et la fréquence basse. La variation de la fréquence d'un résonateur silicium, en fonction de la température, est proche de 30 parties par million (ppm) par degré Celsius. Il a été montré que l'on pouvait obtenir un tirage de l'ordre de 100 ppm pour un résonateur de ce type. Le résonateur de type silicium ne peut alors être compensé que sur une gamme d'environ 3 degrés Celsius, ce qui est insuffisant pour une application industrielle.

Dans le document EP 1 475 885, une compensation thermique similaire à celle proposée par le document JP 58 173488 est effectuée mais, de plus, un diviseur de fréquence variable est placé sur la sortie de l'oscillateur, la température mesurée agissant, par l'intermédiaire d'un circuit de compensation, sur un banc de capacités commutables commandé numériquement (ou sur une capacité variable commandée par un convertisseur numérique-analogique) et également sur le facteur de division du diviseur. Ainsi, la plage de compensation en température est étendue. Toutefois, le diviseur de fréquence variable est réalisé au moyen d'une PLL, dont le facteur N/M est proche de l'unité, ce qui pénalise la consommation. De plus, du fait de la non-linéarité des caractéristiques de réglage, une calibration doit être effectuée en de nombreux points de température différents, rendant le dispositif complexe à mettre en oeuvre.

La présente invention propose un dispositif de compensation en température d'un résonateur permettant d'éviter ces désavantages.

Divulgation de l'invention

Un objet de la présente invention est de fournir un dispositif permettant de générer une fréquence compensée programmable stable sur une gamme de température étendue à partir d'un résonateur piézoélectrique de type silicium.

Un autre objet de la présente invention est de prévoir un procédé de compensation thermique électronique de la fréquence de référence d'un résonateur piézoélectrique de type silicium.

Plus particulièrement, l'invention concerne un dispositif apte à compenser les tolérances de fabrication et la dérive en température d'une fréquence de référence d'un résonateur piézoélectrique de type silicium, générant une fréquence de référence compensée Fref programmable. Le dispositif comprend :

- un capteur de température apte à mesurer une température de fonctionnement du résonateur et apte à fournir un premier signal correspondant à la température,
- un séquenceur relié au capteur de température, le séquenceur étant apte à déterminer un deuxième signal de compensation, à partir du premier signal et en fonction de la valeur de la température, au moyen de données de calibration destinées à être stockées dans un moyen de stockage relié au séquenceur, le deuxième signal correspondant à une valeur positive N, le séquenceur étant, en outre, apte à déterminer un troisième signal de compensation, à partir du premier signal et en fonction de la valeur de la température, au moyen des données de calibration destinées à être stockées dans le moyen de stockage relié au séquenceur, le troisième signal correspondant à un rapport entre un entier positif S et N, S étant inférieur ou égal à N,
- un compteur variable relié audit séquenceur et relié à un oscillateur muni dudit résonateur, ledit compteur variable étant apte à recevoir lesdits signaux de compensation, apte à produire un quatrième signal de sortie chaque N périodes d'un signal d'horloge provenant dudit résonateur, et apte à détecter l'état S, agencé pour produire un cinquième signal apte à modifier la capacité de charge dudit oscillateur.

Selon l'invention, N comprend une partie entière Nint et une partie fractionnaire Nfrac, et le compteur variable comprend :

- un accumulateur relié à la sortie du séquenceur et apte à recevoir un sixième signal correspondant à la partie fractionnaire de N,
- un compteur bi-module Nint, Nint+1 relié à la sortie de l'accumulateur et à la sortie du séquenceur, apte à recevoir un septième signal correspondant à la partie entière de N, et dont la sortie est la fréquence de référence compensée Fref,
- un élément de comptage relié à la sortie du séquenceur et à la sortie du compteur bi-module, apte à recevoir ledit troisième signal et ledit quatrième signal, ledit élément de comptage étant apte à produire le cinquième signal en fonction de l'état S.

L'invention concerne également un procédé de compensation des tolérances de fabrication et de la dérive en température d'une fréquence de référence d'un résonateur piézoélectrique de type silicium comprenant les étapes suivantes :

- mise en fonctionnement d'un capteur de température par un séquenceur reliée audit capteur,
- lecture d'un premier signal correspondant à une mesure de température de fonctionnement du résonateur, le premier signal étant issu du capteur de température,
- détermination d'un deuxième signal de compensation à partir du premier signal par le séquenceur au moyen de données de calibration stockées dans un moyen de stockage relié au séquenceur, le deuxième signal correspondant à une valeur positive N,
- détermination d'un troisième signal de compensation à partir du premier signal par le séquenceur au moyen des données de calibration, le troisième signal correspondant à un rapport entre un entier positif S et N, S étant inférieur ou égal à N,
- réception des signaux compensés par un compteur variable relié au séquenceur et à un oscillateur muni du résonateur,
- production d'un quatrième signal de sortie par le compteur variable chaque N périodes d'un signal d'horloge provenant du résonateur,
- détection de l'état S inférieur ou égal à N, dans le but de produire un cinquième signal apte à modifier la capacité de charge dudit oscillateur.

Brève description des dessins

D'autres caractéristiques de la présente invention apparaîtront plus clairement à la lecture de la description qui va suivre, faite en référence au dessin annexé, dans lequel:

- la figure 1 représente une structure d'oscillateur classiquement utilisée en association avec un résonateur ;
- la figure 2 représente un dispositif de compensation d'un premier mode de réalisation selon la présente invention ;
- la figure 3 représente un dispositif de compensation d'un deuxième mode de réalisation selon la présente invention.

Mode(s) de réalisation de l'invention

Par souci de clarté, de mêmes éléments ont été désignés par les mêmes références dans les différentes figures.

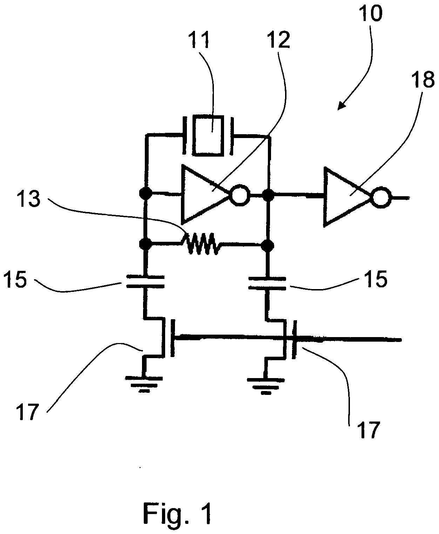

Sur la figure 1 est représenté un exemple d'oscillateur 10 associé à un résonateur 11 piézoélectrique. L'oscillateur 10 comprend un premier inverseur 12 placé entre les noeuds du résonateur 11 et une résistance de polarisation 13 connectée aux bornes de l'oscillateur 10. Dans le cadre d'un mode bi-fréquence, l'oscillateur est connecté à un banc d'une ou de deux capacités 15 commutables : chacune des deux capacités 15 est reliée à la masse par un interrupteur pouvant être un transistor 17 de type MOS. Si l'oscillateur 10 est utilisé comme une sortie d'une base de temps pour le maintien d'une horloge temps réel, un deuxième inverseur 18 identique au premier inverseur 12 est connecté audit oscillateur 10.

La fréquence d'oscillation de l'oscillateur 10 peut être rendue variable en ajustant la capacité de charge au moyen des capacités 15 commutables. En mode bi-fréquence, on parle de différence de tirage. Le décalage de fréquence entre la fréquence de résonance et la fréquence d'oscillation du résonateur 11 correspond à ce tirage. Par exemple, la fréquence d'oscillation dépendant (inversement proportionnelle) de la capacité de charge, le tirage est donc nul pour une capacité de charge infini. On comprend donc qu'en agissant sur ces capacités de charge, il est possible de modifier la fréquence d'oscillation de manière à compenser une éventuelle dérive thermique.

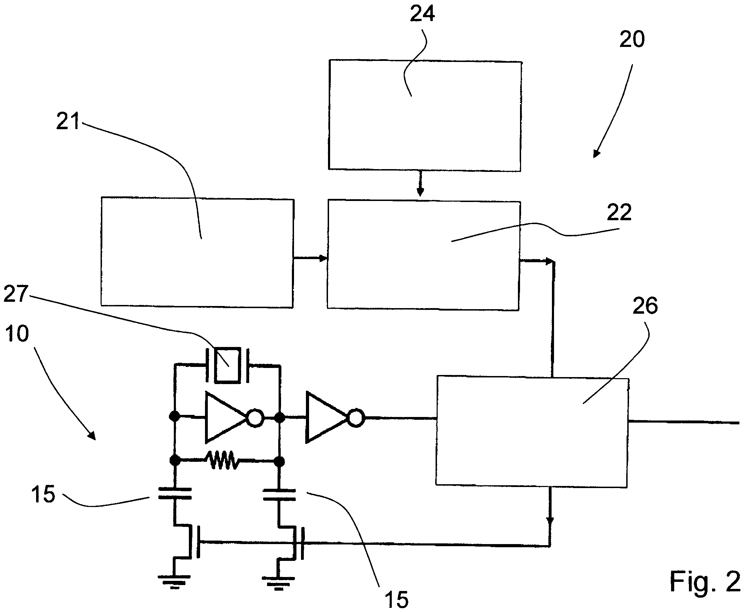

La figure 2 représente, selon un premier mode de réalisation de l'invention, un dispositif 20 apte à compenser la dérive en température d'une fréquence de référence d'un résonateur piézoélectrique de type silicium 27. Il comprend un capteur de température 21 relié à un séquenceur 22 pouvant être une machine d'états ou un microcontrôleur. Le capteur de température 21 peut être un transducteur capable de convertir une forme d'énergie en une autre forme qui peut être préférentiellement une mesure électrique. Une mémoire 24, directement reliée au séquenceur 22, permet de stocker des données de calibration. Le séquenceur 22 est directement connecté à un compteur variable 26 qui commande les capacités commutables 15 décrites à la figure 1. Le compteur variable 26 est typiquement un diviseur de fréquences variable c'est-à-dire que la valeur utilisée, par exemple un entier positif N, pour diviser une fréquence donnée, est paramétrable.

Le capteur de température 21 mesure une température de fonctionnement du circuit à intervalles définis et fournit un premier signal correspondant à la température mesurée. Le séquenceur 22 détermine un deuxième signal de compensation intégrant la valeur de la température, à partir du premier signal au moyen des données de calibration, le deuxième signal représentant la valeur N. De la même manière, le séquenceur 22 délivre un troisième signal représentant un rapport entre un entier positif S et l'entier N, S étant inférieur ou égal à N. Ce rapport correspond à un taux d'activité. Le compteur variable 26 est attaqué par le deuxième signal et le troisième signal. Le compteur 26 génère un quatrième signal de sortie, chaque N périodes d'un signal d'horloge provenant du résonateur 27. Ce compteur 26 joue le rôle d'un diviseur de fréquences qui produit un cycle chaque N périodes du signal reçu en entrée. Le quatrième signal correspond au signal de fréquence de référence compensée Fref. En outre, le compteur 26 possède une fonction supplémentaire, à savoir celle de détecter l'état S. Le compteur produit ainsi un cinquième signal apte à modifier la capacité de charge de l'oscillateur 10 pour produire un signal à fréquence haute ou basse. Ce cinquième signal produit une valeur qui change en fonction de la véracité de l'inégalité définie par l'état S inférieur ou égal à l'état N. Le taux d'activité peut ainsi être réglé. Ce taux d'activité correspond au temps moyen que l'oscillateur 10 passe en fréquence basse pendant N cycles du signal de l'oscillateur.

Les variations de fréquences du résonateur de type silicium 27 en fonction de la température peuvent faire l'objet d'une approximation par une fonction de type linéaire, la fonction pouvant également être d'ordre supérieur. Les paramètres de cette fonction peuvent être stockés dans la mémoire 24. La fonction peut être calculée par le séquenceur 22 en fonction du premier signal.

Le séquenceur 22 met également en fonctionnement le capteur de température aux intervalles définis. La valeur de la température peut, à titre d'exemple, correspondre à une valeur de tension électrique, elle-même convertie dans un format numérique au moyen d'un convertisseur analogique numérique. A l'aide des données de calibration, le séquenceur 22 va donc calculer une valeur de registre qui est appliquée sur le compteur variable 26 dans le but de changer le nombre de cycles à décompter en fonction de la valeur de température mesurée par le capteur. Il est typiquement utilisé un registre de 16 bits. Lorsque le taux d'activité sort d'un intervalle compris entre 0 et 1, le nombre de cycles à décompter change.

La variation relative linéarisée de la fréquence divisée, appelée df, en fonction d'un écart de température, noté AT, de la valeur du taux de division N et de la valeur du taux d'activité, appelé dc, est définie par l'équation suivante :

$$df(\Delta T, N, dc) = \frac{\dfrac{f_o}{N} \cdot (1 + \alpha \cdot \Delta T + dc \cdot \Delta f_{HL}) - \dfrac{f_o}{N_o} \cdot (1 + dc_o \cdot \Delta f_{HL})}{\dfrac{f_o}{N_o} \cdot \left(1 + dc_o \cdot \Delta f_{HL}\right)} \quad (1)$$

où $\Delta f_{HL}$ correspond à l'écart de fréquence relatif entre la fréquence haute et basse, le coefficient $\alpha$ est le coefficient linéaire de variation de fréquence du résonateur en fonction de la température, $N_0$ est le taux de division permettant de compenser les tolérances de fabrication à la température de calibration pour obtenir une fréquence de référence donnée et $dc_0$ est le taux d'activité correspondant, i.e. défini par le rapport entre S et No.

[0023] La condition pour compenser la dérive linéaire du résonateur de type silicium est obtenue en annulant la variation relative de la fréquence. Cela correspond à l'équation suivante :

$$dc(\Delta T, N) = \frac{1}{\Delta f_{HL}}\left(\frac{N - N_o}{N_o} - \alpha \cdot \Delta T\right) + \frac{N}{N_o} \cdot dc_o \quad (2)$$

Il est alors obtenu le taux d'activité dc en fonction du taux de division N et l'écart de température $\Delta T$.

Le contrôle du dispositif objet de l'invention se fait de la manière suivante : lorsque la valeur calculée du taux d'activité sort de l'intervalle admissible, i.e. entre 0 et 1, un ajustement du taux de division est alors commandé. Le taux d'activité est donc recentré. C'est le séquenceur 22 qui calcule la valeur N et le taux d'activité défini par le rapport entre S et N selon l'équation (2).

Dans une volonté d'optimiser l'intégration des divers composants électroniques, on peut prévoir d'intégrer sur un même substrat en matériau semi-conducteur tel que du silicium le capteur 21 et le résonateur 27. En effet, la technologie CMOS le permet. On peut également utiliser deux substrats différents. Ils seront ensuite assemblés par le procédé connu dit de « flip-chip » en s'assurant d'avoir le résonateur sous vide. Bien que les deux substrats soient différents, ils sont, de préférence, constitués du même matériau, typiquement du silicium, pour disposer de la même conductibilité thermique et éviter ainsi les gradients thermiques.

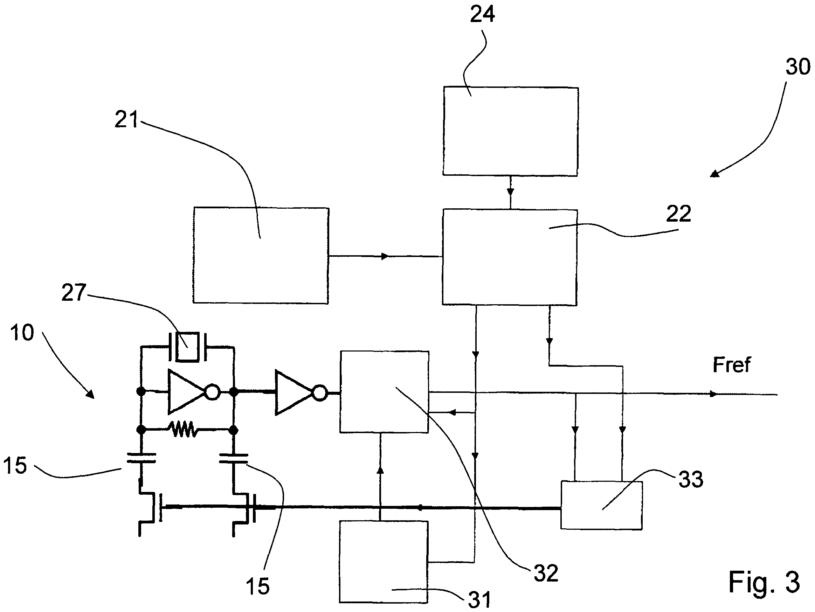

La figure 3 prévoit un deuxième mode de réalisation d'un dispositif de compensation en température d'une fréquence d'un résonateur de type silicium. A la différence du premier mode de réalisation présenté sur la figure 2 et dans lequel la fréquence compensée est générée directement par division entière, la seconde implémentation permet de générer par un dispositif 30, une fréquence compensée qui correspond à une puissance de deux multipliée par la fréquence compensée obtenue selon le premier mode de réalisation.

De manière comparable au dispositif 20 ci-dessus, ce dispositif 30 comprend le capteur de température 21 relié au séquenceur 22, et la mémoire 24 avec la même fonction que précédemment.

Le séquenceur 22 est relié à un accumulateur 31 et à un compteur bi-module 32. Les deux éléments 31 et 32 sont connectés entre eux. Le séquenceur 22 est en outre relié à un élément de comptage, pouvant être notamment un compteur fixe 33 ou un accumulateur de premier ordre ou d'ordre supérieur. Selon l'exemple, l'élément de comptage est un compteur fixe 33 divisant par M, dont un des signaux de sortie défini ci-après attaque les capacités commutées 15 de l'oscillateur 10.

A l'instar du dispositif 20, le séquenceur 22 détermine le deuxième signal représentant la valeur N qui, dans le cas du dispositif 30, n'est pas entière mais comporte une partie fractionnaire Nfrac. Un sixième signal correspondant à la partie fractionnaire Nfrac de N attaque l'accumulateur 31 qui a le même nombre de bits que Nfrac. Un septième signal correspondant à la partie entière Nint de N attaque le compteur bi-module 32. Lorsqu'il est plein (carry output ou retenue = 1), l'accumulateur commute le compteur bi-module à sa valeur supérieure (Nint+1) sans cependant mémoriser (accumuler) ce bit de commande. L'accumulateur 31 est typiquement un intégrateur discret borné.

Comme dans le premier mode de réalisation, le séquenceur délivre le troisième signal représentant le rapport entre S et M, S étant inférieur ou égal à M. Le compteur fixe 33 est attaqué par le troisième signal. Le compteur bi-module 32 génère le quatrième signal de sortie chaque Nint ou Nint+1 périodes du signal d'horloge provenant du résonateur 27. Ce signal correspond au signal de fréquence de référence compensée Fref défini ci-dessus selon le schéma de la figure 2, multiplié par $2^i$, i étant le nombre de bits de Nfrac. Il résulte que la fréquence moyenne du signal obtenu sur une période de Fref est rigoureusement égale à Fref. En outre, le compteur 33 possède une fonction supplémentaire, à savoir celle de détecter l'état S inférieur à la valeur fixe du compteur M. L'un des signaux de sortie mentionné ci-dessus est, comme dans le premier mode de réalisation, le cinquième signal apte à modifier la capacité de charge de l'oscillateur 10 pour produire un signal à fréquence haute ou basse. Ce type de compteur est typiquement un diviseur de fréquences, qui divise la valeur de la fréquence d'un signal d'entrée par une valeur prédéterminée fixe. Ce cinquième signal produit une valeur qui change en fonction de la véracité de l'inégalité définie par l'état S inférieur ou égal à l'état fixé par le compteur 33. Le taux d'activité entre la fréquence haute et la fréquence basse défini par le ratio entre S et M est ainsi contrôlé grâce à ce compteur 33.

A titre d'exemple numérique, il peut être généré par le premier mode de réalisation une fréquence de 32 Hz à partir du résonateur 27 de type silicium à 1 MHz. Cette fréquence étant très spécifique, il est avantageux d'utiliser la deuxième implémentation permettant de générer de manière exacte la fréquence moyenne d'un résonateur à quartz, à savoir 32768 Hz. En effet, étant donné que la fréquence exacte d'un résonateur à quartz est directement égale à

$2^{10}$fois 32 Hz, la valeur de division du compteur 33 peut être fixée à M=1024, c'est-à-dire $2^{10}$.

La solution proposée est donc compatible avec tout type de dispositif comportant habituellement un quartz horloger et permet également de générer n'importe quelle fréquence de référence compensée Fref inférieure à la fréquence du résonateur silicium par simple programmation.

Bien entendu, la présente invention est susceptible de diverses variantes et modifications qui apparaîtront à l'homme de l'art. En particulier, il est à noter que d'autres types d'oscillateurs peuvent être associés à un résonateur piézoélectrique ou électrostatique de type silicium. A titre d'exemple non limitatif, il peut être cité le document EP 1 265 352 au nom de la demanderesse dans lequel est divulgué un oscillateur différentiel rentrant dans le cadre de l'invention telle que définie dans la présente demande. De plus, un mode bi-fréquence a été présenté dans la description. L'invention fonctionnerait également pour un oscillateur multifréquence.

**Revendications**

1. Dispositif apte à compenser les tolérances de fabrication et la dérive en température d'une fréquence de référence d'un résonateur de type silicium (27), générant une fréquence de référence compensée Fref programmable, comprenant :

   - un capteur de température (21) apte à mesurer une température de fonctionnement dudit résonateur (27) et apte à fournir un premier signal correspondant à la température,
   - un séquenceur (22) relié audit capteur de température (21), ledit séquenceur (22) étant apte à déterminer un deuxième signal de compensation, à partir du premier signal et en fonction de la valeur de ladite température, au moyen de données de calibration destinées à être stockées dans un moyen de stockage (24) relié audit séquenceur (22), ledit deuxième signal correspondant à une valeur positive N, ledit séquenceur (22) étant, en outre, apte à déterminer un troisième signal de compensation, à partir dudit premier signal et en fonction de la valeur de ladite température, au moyen des données de calibration, ledit troisième signal correspondant à un rapport entre un entier positif S et N, S étant inférieur ou égal à N,
   - un compteur variable (26) relié audit séquenceur (22) et relié à un oscillateur (10) muni dudit résonateur (27), ledit compteur variable (26) étant apte à recevoir lesdits signaux de compensation, apte à produire un quatrième signal de sortie chaque N périodes d'un signal d'horloge provenant dudit résonateur (27), et apte à détecter l'état S, agencé pour produire un cinquième signal apte à modifier la capacité de charge dudit oscillateur (10), dans lequel N comprend une partie entière Nint et une partie fractionnaire Nfrac, et dans lequel le compteur variable (26) comprend :
   - un accumulateur (31) relié à la sortie du séquenceur (22) et apte à recevoir un sixième signal correspondant à la partie fractionnaire de N,
   - un compteur bi-module Nint, Nint+1 (32) relié à la sortie de l'accumulateur (31) et à la sortie du séquenceur (22), apte à recevoir un septième signal correspondant à la partie entière de N, et dont la sortie est la fréquence de référence compensée Fref,
   - un élément de comptage (33) relié à la sortie du séquenceur (22) et à la sortie du compteur bi-module (32), apte à recevoir ledit troisième signal et ledit quatrième signal, ledit élément de comptage (33) étant apte à produire le cinquième signal en fonction de l'état S.

2. Dispositif selon la revendication 1, dans lequel l'oscillateur est connecté à un banc de deux capacités (15) reliées chacune respectivement à un transistor (17).

3. Dispositif selon la revendication 1, dans lequel ledit dispositif comprend un convertisseur analogique digital placé entre ledit capteur (21) et ledit séquenceur (22) et apte à convertir ladite température de fonctionnement en une tension numérique.

4. Dispositif selon la revendication 2, dans lequel ledit dispositif comprend un convertisseur analogique digital placé entre ledit capteur (21) et ledit séquenceur (22) et apte à convertir ladite température de fonctionnement en une tension numérique.

5. Dispositif selon la revendication 1, dans lequel ledit séquenceur (22) est apte à mettre en fonctionnement ledit capteur de température (21) et apte à lire le signal correspondant à ladite température.

6. Dispositif selon la revendication 2, dans lequel ledit séquenceur (22) est apte à mettre en fonctionnement ledit capteur de température (21) et apte à lire le signal correspondant à ladite température.

**7.** Dispositif selon la revendication 3, dans lequel ledit séquenceur (22) est apte à mettre en fonctionnement ledit capteur de température (21) et apte à lire le signal correspondant à ladite température.

**8.** Dispositif selon la revendication 4, dans lequel ledit séquenceur (22) est apte à mettre en fonctionnement ledit capteur de température (21) et apte à lire le signal correspondant à ladite température.

**9.** Dispositif selon la revendication 1, dans lequel ledit capteur (21) et ledit résonateur (27) sont intégrés sur un même substrat de silicium.

**10.** Dispositif selon la revendication 2, dans lequel ledit capteur (21) et ledit résonateur (27) sont intégrés sur un même substrat de silicium.

**11.** Dispositif selon la revendication 3, dans lequel ledit capteur (21) et ledit résonateur (27) sont intégrés sur un même substrat de silicium.

**12.** Dispositif selon la revendication 5, dans lequel ledit capteur (21) et ledit résonateur (27) sont intégrés sur un même substrat de silicium.

**13.** Dispositif selon l'une des revendications 1 à 8, dans lequel ledit capteur (21) et ledit résonateur (27) sont intégrés respectivement chacun sur un substrat de silicium, lesdits deux substrats étant connectés par « flip-chip ».

**14.** Procédé de compensation des tolérances de fabrication et de la dérive en température d'une fréquence de référence d'un résonateur piézoélectrique de type silicium (27) comprenant les étapes suivantes :

- mise en fonctionnement d'un capteur de température (21) par un séquenceur (22) reliée audit capteur (21),
- lecture d'un premier signal correspondant à une mesure de température de fonctionnement dudit résonateur (27), ledit premier signal étant issu du capteur de température (21),
- détermination d'un deuxième signal de compensation à partir dudit premier signal par le séquenceur (22) au moyen de données de calibration destinées à être stockées dans un moyen de stockage (24) relié audit séquenceur (22), ledit deuxième signal correspondant à une valeur positive N, N comprenant une partie entière Nint et une partie fractionnaire Nfrac,
- détermination d'un troisième signal de compensation à partir dudit premier signal par le séquenceur (22) au moyen des données de calibration, ledit troisième signal correspondant à un rapport entre un entier positif S et N, S étant inférieur ou égal à N,
- réception desdits signaux compensés par un compteur variable (26) relié au séquenceur (22) et à un oscillateur (10) muni dudit résonateur (27), le compteur variable (26) comprenant :

- un accumulateur (31) relié à la sortie du séquenceur (22) et apte à recevoir un sixième signal correspondant à la partie fractionnaire de N,
- un compteur bi-module Nint, Nint+1 (32) relié à la sortie de l'accumulateur (31) et à la sortie du séquenceur (22), apte à recevoir un septième signal correspondant à la partie entière de N,
- un élément de comptage (33) relié à la sortie du séquenceur (22) et à la sortie du compteur bi-module (32), apte à recevoir ledit troisième signal et ledit quatrième signal, ledit compteur fixe (33) étant apte à détecter l'état S et à produire le cinquième signal en fonction de l'état S.

- production d'un quatrième signal de sortie par le compteur variable (26) chaque N périodes d'un signal d'horloge provenant dudit résonateur (27),
- détection de l'état S inférieur ou égal à N, dans le but de produire un cinquième signal apte à modifier la capacité de charge dudit oscillateur (10).

**Claims**

**1.** A device capable of compensating for manufacturing tolerances and the temperature shift of a reference frequency of a resonator of the silicon type (27), generating a programmable compensated reference frequency Fref, comprising:

- a temperature sensor (21) capable of measuring an operating temperature of said resonator (27) and capable of providing a first signal corresponding to the temperature,

- a sequencer (22) connected to said temperature sensor (21), said sequencer (22) being capable of determining a second compensation signal from the first signal and depending on the value of said temperature, by means of calibration data intended to be stored in a storage means (24) connected to said sequencer (22), said second signal corresponding to a positive value N, said sequencer (22) further being capable of determining a third compensation signal from said first signal and depending on the value of said temperature, by means of calibration data, said third signal corresponding to a ratio between a positive integer S and N, S being less than or equal to N,

- a variable counter (26) connected to said sequencer (22) and connected to an oscillator (10) provided with said resonator (27), the variable counter (26) being capable of receiving said compensation signals, capable of producing a fourth output signal every N periods of a clock signal from said resonator (27), and capable of detecting the S state, laid out so as to produce a fifth signal capable of modifying the load capacitance of said oscillator (10),

wherein N comprises an integer portion Nint and a fractional portion Nfrac, and wherein the variable counter (26) comprises:

- an accumulator (31) connected to the output of the sequencer (22) and capable of receiving a sixth signal corresponding to the fractional portion of N,
- a two-module counter Nint, Nint+1 (32) connected to the output of the accumulator (31) and to the output of the sequencer (22) capable of receiving a seventh signal corresponding to the integer portion of N, and the output of which is the compensated reference frequency Fref,
- a counting member (33) connected to the output of the sequencer (22) and to the output of the two-module counter (32), capable of receiving said third signal and said fourth signal, said counting member (33) being capable of producing the fifth signal depending on the S state.

2. The device according to claim 1, wherein the oscillator is connected to a bench of two capacitors (15) each connected to a transistor (17), respectively.

3. The device according to claim 1, wherein said device comprises an analog/digital converter placed between said sensor (21) and said sequencer (22) and capable of converting said operating temperature into a digital voltage.

4. The device according to claim 2, wherein said device comprises an analog/digital converter placed between said sensor (21) and said sequencer (22) and capable of converting said operating temperature into a digital voltage.

5. The device according to claim 1, wherein said sequencer (22) is capable of starting the operation of said temperature sensor (21) and capable of reading the signal corresponding to said temperature.

6. The device according to claim 2, wherein said sequencer (22) is capable of starting the operation of said temperature sensor (21) and capable of reading the signal corresponding to said temperature.

7. The device according to claim 3, wherein said sequencer (22) is capable of starting the operation of said temperature sensor (21) and capable of reading the signal corresponding to said temperature.

8. The device according to claim 4, wherein said sequencer (22) is capable of starting the operation of said temperature sensor (21) and capable of reading the signal corresponding to said temperature.

9. The device according to claim 1, wherein said sensor (21) and said resonator (27) are integrated on a same silicon substrate.

10. The device according to claim 2, wherein said sensor (21) and said resonator (27) are integrated on a same silicon substrate.

11. The device according to claim 3, wherein said sensor (21) and said resonator (27) are integrated on a same silicon substrate.

12. The device according to claim 5, wherein said sensor (21) and said resonator (27) are integrated on a same silicon substrate.

**13.** The device according to one of claims 1 to 8, wherein said sensor (21) and said resonator (27) are each respectively integrated onto a silicon substrate, said two substrates being connected by a « flip chip ».

**14.** A method for compensating for manufacturing tolerances and the temperature shift of a reference frequency of a piezoelectric resonator of the silicon type (27) comprising the following steps:

- starting the operation of a temperature sensor (21) by a sequencer (22) connected to said sensor (21),
- reading a first signal corresponding to a measurement of the operating temperature of said resonator (27), said first signal stemming from the temperature sensor (21),
- determining a second compensation signal from said first signal by the sequencer (22) by means of calibration data intended to be stored in a storage means (24) connected to said sequencer (22), said second signal corresponding to a positive value N, N comprising an integer portion Nint and a fractional portion Nfrac,
- determining a third compensation signal from said first signal by the sequencer (22) by means of the calibration data, said third signal corresponding to a ratio between a positive integer S and N, S being less than or equal to N,
- receiving said compensated signals by a variable counter (26) connected to the sequencer (22) and to an oscillator (10) provided with said resonator (27), the variable counter (26) comprising:

- an accumulator (31) connected to the output of the sequencer (22) and capable of receiving a sixth signal corresponding to the fractional portion of N,
- a two-module counter Nint, Nint+1 (32) connected to the output of the accumulator (31) and to the output of the sequencer (22), capable of receiving a seventh signal corresponding to the integer portion of N,
- a counting member (33) connected to the output of the sequencer (22) and to the output of the two-module counter (32), capable of receiving said third signal and said fourth signal, said fixed counter (33) being capable of detecting the state S and of producing the fifth signal depending on the state S,

- a fourth output signal by the variable counter (26) every N periods of a clock signal from said resonator (27),
- detecting the state S of less than or equal to N, with the purpose of producing a fifth signal capable of modifying the load capacitance of said oscillator (10).

**Patentansprüche**

**1.** Vorrichtung, die imstande ist, die Herstellungstoleranzen und die Temperaturdrift einer Referenzfrequenz eines Resonators vom Typ Silizium (27) zu kompensieren, der eine programmierbare kompensierte Referenzfrequenz Fref erzeugt, die umfasst:

- einen Temperatursensor (21), der imstande ist, eine Betriebstemperatur des Resonators (27) zu messen und imstande, ein erstes Signal zu liefern, das der Temperatur entspricht,
- einen mit dem Temperatursensor (21) verbundenen Sequenzer (22), wobei der Sequenzer (22) imstande ist, ausgehend vom ersten Signal und in Abhängigkeit des Temperaturwerts ein zweites Kompensationssignal mit Hilfe von Kalibrierungsdaten zu bestimmen, die dazu bestimmt sind, in einem mit dem Sequenzer (22) verbundenen Speichermittel (24) gespeichert zu sein, wobei das zweite Signal einem positiven Wert N entspricht, wobei der Sequenzer (22) weiterhin imstande ist, ausgehend vom ersten Signal und in Abhängigkeit des Temperaturwerts mit Hilfe der Kalibrierungsdaten ein drittes Kompensationssignal zu bestimmen, wobei das dritte Signal einem Verhältnis zwischen einer positiven Ganzzahl S und N entspricht, wobei S kleiner oder gleich N ist,
- einen variablen Zähler (26), der mit dem Sequenzer (22) verbunden ist und mit einem Oszillator (10) verbunden ist, der mit dem Resonator (27) ausgestattet ist, wobei der variable Zähler (26) imstande ist, die Kompensationssignale zu empfangen, imstande, bei jeder N-Periode eines Zeitsignals des Resonators (27) ein viertes Ausgangssignal zu produzieren und imstande, den Zustand S zu ermitteln, ausgebildet, um ein fünftes Signal zu produzieren, das imstande ist, die Belastbarkeit des Oszillators (10) zu ändern, wobei N einen ganzen Teil Nint und einen Dezimalteil Nfrac umfasst, und wobei der variable Zähler (26) umfasst:
- einen Akkumulator (31), der mit dem Ausgang des Sequenzers (22) verbunden ist und imstande, ein sechstes Signal zu empfangen, das dem Dezimalteil von N entspricht,
- einen bimodularen Zähler Nint, Nint+1 (32), der mit dem Ausgang des Akkumulators (31) und mit dem Ausgang des Sequenzers (22) verbunden ist, der imstande ist, ein sechstes Signal zu empfangen, das dem ganzen Teil von N entspricht, und dessen Ausgang die kompensierte Referenzfrequenz Fref ist,
- ein Zählelement (33), das mit dem Ausgang des Sequenzers (22) und mit dem Ausgang des bimodularen Zählers (32) verbunden ist, das imstande ist, das dritte Signal und das vierte Signal zu empfangen, wobei das Zählelement (33) imstande ist, das fünfte Signal in Abhängigkeit vom Zustand S zu produzieren.

2. Vorrichtung nach Anspruch 1, wobei der Oszillator mit einer Bank mit zwei Kapazitäten (15) verbunden ist, die jeweils mit einem Transistor (17) verbunden sind.

3. Vorrichtung nach Anspruch 1, wobei die Vorrichtung einen Analog-DigitalWandler umfasst, der zwischen dem Sensor (21) und dem Sequenzer (22) platziert ist und imstande, die Betriebstemperatur in eine digitale Spannung umzuwandeln.

4. Vorrichtung nach Anspruch 2, wobei die Vorrichtung einen Analog-DigitalWandler umfasst, der zwischen dem Sensor (21) und dem Sequenzer (22) platziert ist und imstande, die Betriebstemperatur in eine digitale Spannung umzuwandeln.

5. Vorrichtung nach Anspruch 1, wobei der Sequenzer (22) imstande ist, den Temperatursensor (21) in Betrieb zu setzen und imstande, das der Temperatur entsprechende Signal zu lesen.

6. Vorrichtung nach Anspruch 2, wobei der Sequenzer (22) imstande ist, den Temperatursensor (21) in Betrieb zu setzen und imstande, das der Temperatur entsprechende Signal zu lesen.

7. Vorrichtung nach Anspruch 3, wobei der Sequenzer (22) imstande ist, den Temperatursensor (21) in Betrieb zu setzen und imstande, das der Temperatur entsprechende Signal zu lesen.

8. Vorrichtung nach Anspruch 4, wobei der Sequenzer (22) imstande ist, den Temperatursensor (21) in Betrieb zu setzen und imstande, das der Temperatur entsprechende Signal zu lesen.

9. Vorrichtung nach Anspruch 1, wobei der Sensor (21) und der Resonator (27) auf einem selben Siliziumsubstrat integriert sind.

10. Vorrichtung nach Anspruch 2, wobei der Sensor (21) und der Resonator (27) auf einem selben Siliziumsubstrat integriert sind.

11. Vorrichtung nach Anspruch 3, wobei der Sensor (21) und der Resonator (27) auf einem selben Siliziumsubstrat integriert sind.

12. Vorrichtung nach Anspruch 5, wobei der Sensor (21) und der Resonator (27) auf einem selben Siliziumsubstrat integriert sind.

13. Vorrichtung nach einem der Ansprüche 1 bis 8, wobei der Sensor (21) und der Resonator (27) jeweils auf einem Siliziumsubstrat integriert sind, wobei die zwei Substrate durch "Flip-Chip" verbunden sind.

14. Verfahren zur Kompensation der Herstellungstoleranzen und der Temperaturdrift einer Referenzfrequenz eines piezoelektrischen Resonators vom Typ Silizium (27), das die folgenden Schritte umfasst:

- Inbetriebsetzen eines Temperatursensors (21) durch einen mit dem Sensor (21) verbundenen Sequenzer (22),
- Lesen eines ersten Signals, das einer Betriebstemperaturmessung des Resonators (27) entspricht, wobei das erste Signal vom Temperatursensor (21) geliefert wurde,
- Bestimmen eines zweiten Kompensationssignal ausgehend vom ersten Signal durch den Sequenzer (22) mit Hilfe von Kalibrierungsdaten, die dazu bestimmt sind, in einem mit dem Sequenzer (22) verbundenen Speichermittel (24) gespeichert zu sein, wobei das zweite Signal einem positiven Wert N entspricht, wobei N einen ganzen Teil Nint und einen Dezimalteil Nfrac umfasst,
- Bestimmen eines dritten Kompensationssignals ausgehend vom ersten Signal durch den Sequenzer (22) mit Hilfe der Kalibrierungsdaten, wobei das dritte Signal einem Verhältnis zwischen einer positiven Ganzzahl S und N entspricht, wobei S kleiner oder gleich N ist,
- Empfangen der kompensierten Signale durch einen variablen Zähler (26), der mit dem Sequenzer (22) und einem Oszillator (10) verbunden ist, der mit dem Resonator (27) ausgestattet ist, wobei der variable Zähler (26) umfasst:

- einen Akkumulator (31), der mit dem Ausgang des Sequenzers (22) verbunden ist und imstande, ein sechstes Signal zu empfangen, das dem Dezimalteil von N entspricht,

- einen bimodularen Zähler Nint, Nint+1 (32), der mit dem Ausgang des Akkumulators (31) und mit dem Ausgang des Sequenzers (22) verbunden ist, imstande, ein sechstes Signal zu empfangen, das dem ganzen Teil von N entspricht,

- ein Zählelement (33), das mit dem Ausgang des Sequenzers (22) und mit dem Ausgang des bimodularen Zählers (32) verbunden ist, imstande, das dritte Signal und das vierte Signal zu empfangen, wobei der feste Zähler (33) imstande ist, den Zustand S zu ermitteln und das fünfte Signal in Abhängigkeit vom Zustand S zu produzieren,

- Produzieren eines vierten Ausgangssignals durch den variablen Zähler (26) bei jeder N-Periode eines Zeitsignals des Resonators (27),

- Feststellen des Zustands S kleiner oder gleich N mit dem Ziel, ein fünftes Signal zu produzieren, das imstande ist, die Belastbarkeit des Oszillators (10) zu ändern.

Fig. 1

Fig. 2

Fig. 3

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 58173488 A
- EP 1475885 A

- EP 1265352 A

**Littérature non-brevet citée dans la description**

- **D. LANFRANCHI et al.** A Microprocessor-Based Analog Wristwatch Chip with 3 Seconds/Year Accuracy. *IEEE,* 1994